# EUROPEAN PATENT APPLICATION

(11) **EP 4 130 348 A1**
(43) Date of publication of application: **08.02.2023**
(21) Application number: 21189238.5
(22) Date of filing: 02.08.2021
(51) Int. Cl.: C30B 15/16, C30B 15/32, C30B 29/06

(54) **DEVICE AND METHOD FOR PRODUCING A MONOCRYSTALLINE SILICON ROD**

(71) Applicant: Siltronic AG, 81677 München (DE)
(72) Inventor: Do, Quoc Thai, 84489 Burghausen (DE); Eschenbacher-Bladt, Patrick, 84489 Burghausen (DE); Raming, Georg, 84367 Tann (DE); Zeman, Otto, 84539 Ampfing (DE)

(57) **Abstract**

Device and method for the production of a crystal according to the Czochralski method. The device comprises a drawing shaft comprising a surface, a seed holder suitable to hold the crystal seed during crystal pulling and a dish in a form of a hollow truncated cone, which builds an opening, comprising a top radius **R₂,** a height **h,** a material thickness **b** and a base plate having a radius **R₁** and a bore having a diameter **d** wherein the dish is secured between the seed holder and the drawing shaft such that the opening faces towards drawing shaft.

## Description

It is an object of the invention to provide a device which allows the production of monocrystalline silicon rods by the Czochralski process with higher dislocation free yields.

Single crystal silicon, which is the starting material for most semiconductor electronic device fabrication processes, is usually produced by the so-called Czochralski ("CZ") process. In this process, polycrystalline silicon ("polysilicon") is placed in a crucible and melted, a seed crystal is brought into contact with the molten silicon, and a single crystal is grown by slow extraction.

Particles generated during crystal growth and entering the melt can cause the grown crystal to become dislocated, resulting in a loss of the desired quality of the crystal. This in turn leads to a significant loss of yield and thus to increased costs.

It must therefore be avoided that particles from the crystal growth system come in contact with the melt or the crystal-melt interface.

In patent application WO 2020 074 285 A1**,** a special heat shield is proposed to prevent particles from the gas phase from falling onto the melt causing the growing crystal to generate defects.

The inventors realized that this measure helps but is far from sufficient to achieve the desired yields.

It is therefore the task of the invention to provide a device which makes it possible to produce a monocrystalline rod without experiencing the described negative effects of dust and particles in the drawing equipment.

The task is solved by the devices described in the claims.

### Brief Description of the Figures

**Figure 1** depicts a preferred embodiment of the invention. The seed holder **(102)** is mounted on the lower part of the drawing shaft **(100)** by means of a thread **(103)** and a dish **(101)** (shown in Fig. 2) is clamped between seed holder and drawing shaft. When in operation the crystal seed can be clamped into the seed holder by holding means **(104).**
**Figure 2** shows a preferred embodiment of the dish **(200)** used in **Fig 1**. The dish is preferably made of carbon fiber reinforced carbon (CFC) having a material thickness **b** of more than 1 mm and less than 5 mm.

The shape of the dish preferably has the form of a hollow truncated cone having a height **h** and having a base plate **(201)** with a base radius **R₁** and a top radius **R₂**. The base plate comprises a bore **(202)** having a bore diameter **d.**

### Abbreviations

- 100: drawing shaft
- 101: dish
- 102: seed holder
- 103: tread
- 104: holding means for seed crystal
- 200: dish
- 201: base plate
- 202: bore in the bas plate
- R₁: radius
- R₂: radius
- h: height
- d: diameter of the bore
- b: thickness of the material used

### Detailed Description of the Invention

During the CZ pulling process, particles (dopants such as P, Sb, As, SiO, SiO₂, Si, etc.) are deposited on the water-cooled drawing shaft of the Czochralski system. These particles can detach, fall towards the melt, and cause dislocations in the crystal.

The invention includes a device for pulling a crystal according to Czochralski, which makes it possible to minimize the negative effects of particles on the integrity of the pulled crystal. In particular, it reduces the likelihood that a crystal will form dislocations during growth due to particles.

The preferred device comprises a drawing shaft which is used during crystal growth to keep the crystal in upright position, rotate and pull up the crystal. The use of a drawing shaft is shown in WO 2020 074 285 A1 for example.

A modified drawing shaft is shown in WO 18 142 541 A1**.** The modified drawing shaft can also be utilized for the invention.

The preferred device also comprises a seed holder that is suitable to hold the crystal seed during crystal pulling. An example of a suitable seed holder is for example shown in WO 2020 074 285 A1**.**

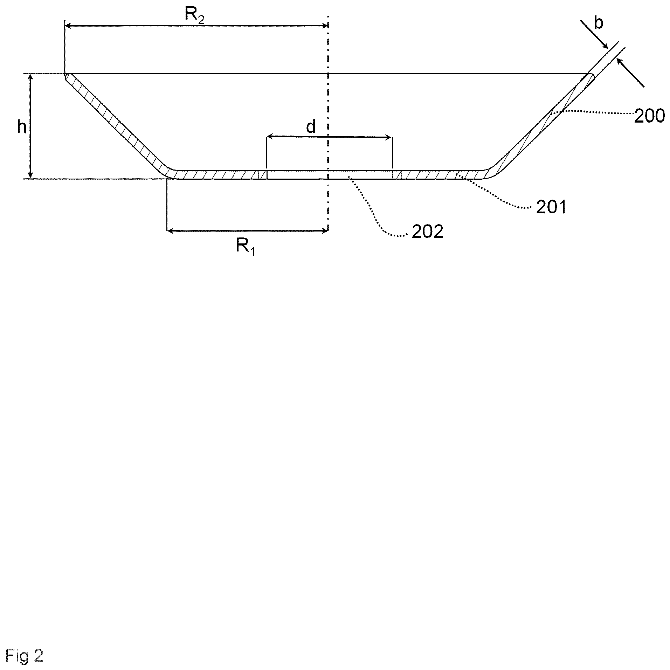

The preferred device also comprises a dish in a form of a hollow truncated cone. A preferred embodiment of this device is shown in **Fig 2****.**

More preferably, the dish is made of carbon fiber reinforced carbon (CFC) having a material thickness **b** of more than 1 mm and less than 5 mm.

Preferably, the shape of the dish has the form of a hollow truncated cone having a height **h** and a base plate **(201)** with a base radius **R₁** and a top radius **R₂**. The base plate comprises a bore **(202)** having a bore diameter **d.**

Most preferably, the height **h** is less than the difference of Radius **R₂** and Radius **R₁**.

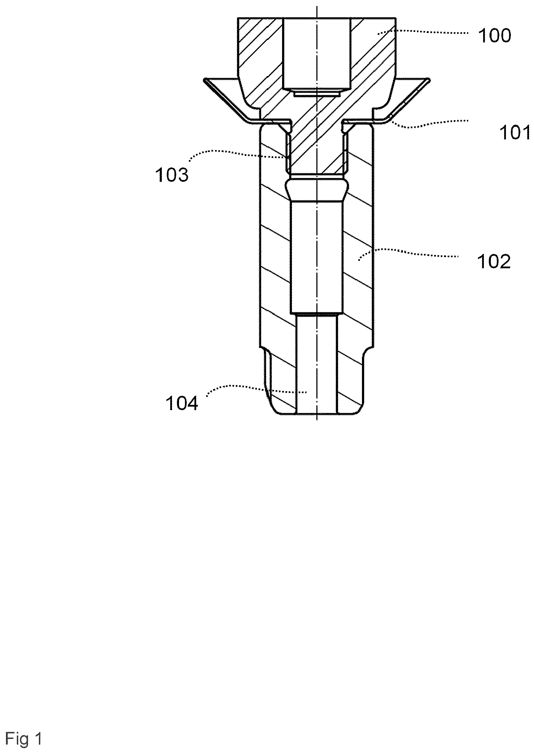

The bore of the baseplate of the dish is used to secure it between the drawing shaft and the seed holder. **Fig 1** exhibits a graphic representation of the preferred embodiment.

In a preferred embodiment the dish is secured between the seed holder and the drawing shaft using a thread as shown in **Fig 2****.**

The inventors realized that the best effect is accomplished if the opening of the dish points towards the drawing shaft. Therefore, it is preferred to secure the opening of the dish facing towards the drawing shaft.

The inventors realized in order to prevent particles from falling into the melt it is additionally very beneficial to wet the drawing shaft with oil. Preferably, a vacuum pump oil is used. It is believed that the coated surface of the drawing shaft offers a sticky surface for particles and therefore prevent them from falling down and enfold their malign behavior.

In the performed experiments the vacuum pump oil of type S2 R100 (by Shell) was used. However, this oil is not rated for high temperatures (above 100°C) and the drawing shaft faces more than 600°C crystals grown with this setup exhibit a lower dislocation rate. Nevertheless, the effect could be seen very clearly.

More preferably, it is very preferable to use said oil to completely wet the dish in addition.

In addition, the invention includes a method for pulling a silicon crystal according to Czochralski. Preferably, the method comprises the following steps:
(a) installing a seed holder on a drawing shaft in a Czochralski crystal pulling apparatus, wherein a dish in a form of a hollow truncated cone is secured between the seed holder and the drawing shaft so that the opening of the dish faces the drawing shaft.
(b) Mounting a crystal seed into the seed holder.
(c) melting polycrystalline silicon in a crucible,
(d) lowering the drawing shaft until the crystal seed gets in contact with the melt
(e) and pulling the crystal.

More preferably the method comprises the wetting of the drawing shaft and the dish with oil. Most preferably, an oil is used that is suitable as vacuum pump oil.

The above description of exemplary embodiments is to be understood as exemplary. On the one hand, the disclosure thus made enables the person skilled in the art to understand the present invention and the advantages associated therewith, and on the other hand, in the understanding of the person skilled in the art, also includes obvious changes and modifications of the structures and methods described. Therefore, all such changes and modifications as well as equivalents shall be covered by the scope of protection of the claims.

## Claims

1. Device for the production of a silicon crystal according to the Czochralski method, comprising
a drawing shaft comprising a surface,
a seed holder suitable to hold the crystal seed during crystal pulling and a dish in a form of a hollow truncated cone, which builds an opening, comprising
a top radius **R₂,** a height **h,**
a material thickness **b**
and a base plate having a radius **R₁** and a bore having a diameter **d**
wherein the dish is secured between the seed holder and the drawing shaft such that the opening faces towards drawing shaft.

2. Device according to claim 1, **characterized in that**
the thickness **b** is not less than 1 mm and not greater than 5 mm.

3. Device according to claim 1, **characterized in that**
the dish is made of carbon fiber reinforced carbon (CFC).

4. Device according to claim 1, **characterized in that**
the height **h** is less than the difference of Radius **R₂** and Radius **R₁**.

5. Device according to claim 1, **characterized in that**
the surface of the drawing shaft is completely wetted with oil.

6. Device according to claim 1, **characterized in that**
the dish is completely wetted with oil.

7. Method for pulling a single crystal comprising the steps of,
installing a seed holder on a drawing shaft in a Czochralski crystal pulling apparatus, wherein a dish in a form of a hollow truncated cone is secured between the seed holder and the drawing shaft so that the opening of the dish faces the drawing shaft,
mounting a crystal seed into the seed holder,
melting polycrystalline silicon in a crucible,
lowering the drawing shaft until the crystal seed gets in contact with the melt and pulling the crystal.

8. Method for pulling a single crystal according to claim 7, **characterized in that** the drawing shaft and the dish is wetted with oil.
